# EUROPEAN PATENT SPECIFICATION

(11) **EP 3 343 640 B1**
(45) Date of publication and mention of the grant of the patent: **01.01.2020**
(21) Application number: 17203012.4
(22) Date of filing: 22.11.2017
(51) Int. Cl.: H01L 31/0236

(54) **METHOD OF SURFACE TEXTURING USING A LASER HEATING STEP THAT CONTRIBUTES TO SMALL-SIZED TEXTURE MORPHOLOGY**
VERFAHREN ZUR OBERFLÄCHENTEXTURIERUNG MIT EINEM LASERHEIZSCHRITT ALS BEITRAG ZU EINER KLEINEN TEXTURMORPHOLOGIE
PROCÉDÉ DE TEXTURATION DE SURFACE UTILISANT UNE ÉTAPE DE CHAUFFAGE AU LASER CONTRIBUANT À LA MORPHOLOGIE D'UNE TEXTURE DE PETITE TAILLE

(30) Priority: 29.12.2016 TR 201620039
(43) Date of publication of application: 04.07.2018
(73) Proprietor: Yerci, Selcuk, 06800 Ankara (TR); Hadibrata, Wisnu, 06800 Ankara (TR)
(72) Inventor: Yerci, Selcuk, 06800 Ankara (TR); Hadibrata, Wisnu, 06800 Ankara (TR)
(74) Representative: Kayahan, Senem

(56) References cited:
- US-A- 4 390 392
- US-A1- 2009 325 336
- US-A1- 2012 295 447
- US-B1- 6 451 218
- US-B1- 8 309 389

## Description

### Technical Field

The invention is related to a method for surface texturing of a silicon wafer.

### Prior Art

Currently, more than 85% of photovoltaics market is dominated by crystalline silicon solar cells. Silicon wafers are typically obtained from a silicon ingot which is then sliced into thin silicon wafers by method of wire sawing. The slicing and wire sawing processes create physical damage to the silicon such as high surface roughness and microcracks that penetrate up to 10 µm into the silicon. This top most layer of damage is called saw-damage region. To achieve high efficiency solar cells, a process of saw-damage removal is often required. Saw-damage removal process is typically carried out using a high concentrated alkaline solution, such as potassium hydroxide (KOH) for single crystal silicon wafers and acidic solution for multi-crystalline silicon wafers. At the end of the process, generally more than 20 µm of silicon is consumed for complete removal of saw-damage region in the wafers.

In conventional state-of-the-art silicon based solar cells, to improve absorption within the silicon absorber layer, light trapping structures on the silicon wafer surface are utilized. For single crystalline silicon solar cells, this is usually achieved by etching of silicon at <100>-crystal orientations with alkaline based solution, for instance KOH and NaOH. The result of the etching process is random upright pyramid structures with sizes in the range of 5 - 15 µm on the surface of the wafers. Smaller pyramids are often preferred to eliminate issues such as in the process of metal screen printing, photolithography, etc. While recent results show that there is no substantial advantage in the optical characteristic of various pyramids sizes, it was shown that cells with smaller pyramids allow for higher fill factor (FF) and hence efficiency [1]. It is mostly due to the fact that better coverage of metal fingers can be obtained on smaller pyramids which results in less resistive loss. Smaller pyramids are also advantageous for silicon wafer with thickness in the order of tens of microns since fabrication of larger pyramids are not feasible at these thicknesses.

US2012/295447 discloses a single crystalline silicon wafer, having upright: pyramids with size samller than 3µm. Pre-texturing composition for texturing silicon wafers having one or more surfactants is used.

In the present invention, damages created in the process of wire sawing are removed without the need of chemical etching process. Instead, laser beam is scanned throughout the wafers to eliminate saw-damage region. Upright pyramids with controlled sizes are fabricated in the same laser scanning process. According to the invention, there is provided a method of texturing a single crystalline silicon wafer as set out in claim 1.

### Description of Figures

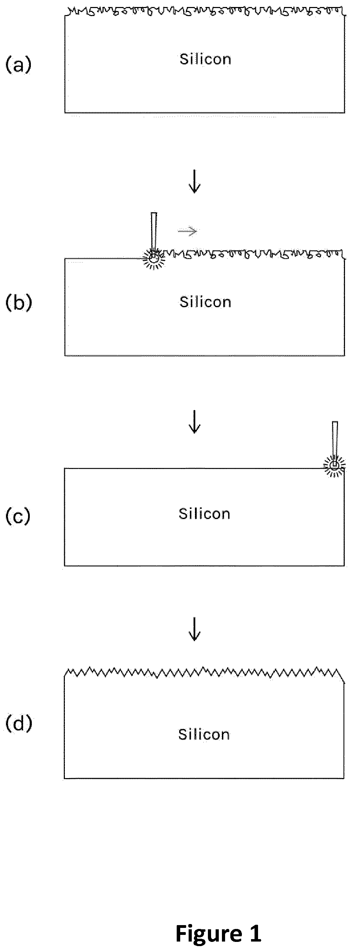

**Figure 1****:** Stages of method of invention
   1(a) saw-damaged silicon wafer with pronounced damage such as micro cracks
   1(b) laser beam is focused and scanned throughout the saw-damage region
   1(c) laser smoothened silicon wafer is obtained
   1(d) texturing process of silicon with alkaline solution which results in pyramids structure on the surface
**Figure 2****.** Surface morphology of saw-damage wafer (a) and laser smoothened (b) wafer. Side view of saw-damaged wafer with apparent micro crack (c) and laser healed silicon wafer with no damage (d).
**Figure 3****.** Pyramid structures on laser-healed silicon surface (a) and saw-damaged (non-treated) silicon surface (b) right after texturing process.
**Figure 4****.** Reflection measurement of pyramid textures on laser healer healed and non-treated silicon wafers.

### Brief Description of Invention

In present invention, in place of saw damaged healing process using KOH solution, a process where laser beam is irradiated and focused onto the surface is performed. In the process, laser with wavelength of 1064 nm is scanned throughout the wafer. When the laser is incident with the surface of silicon, the heat generated due to absorption of the laser by the silicon melts the surface. In a very short time, the molten silicon recrystallizes and forms a smoother silicon surface. The underneath non-irradiated silicon acts as seed layer for the recrystallization of molten silicon. As the result of the process, smooth surface with relatively much lower surface roughness silicon is obtained. In addition, small crack created in the sawing process have also been removed within the process. Within our developed process, saw damaged etching process can be completely eliminated. This will save extra step in the texturing process of silicon as well as save cost of consumables of chemicals. The clear advantage of the present invention is the elimination of material loss due to chemical etching in saw-damage removal process.

In addition to laser healing, a process of texturing of silicon surface with KOH solution is also embedded in the present invention. Different size of pyramids structures on single crystal silicon wafers are possible to be fabricated. This is directly related to the fact that the surface morphology of laser healed region is different to that of non-treated region. Indeed, upright pyramids with size less than 3 µm have successfully been fabricated. The proposed process has the advantage of shorter process time to achieve desired surface morphology.

### Detailed Description of the Invention

The present invention proposes a process which involves the usage of laser beam to remove saw-damage region from saw-damaged silicon wafers. This process completely replaces the need of resource-consuming wet chemical etching saw-damage removal process. In addition, the present invention proposes to utilized the laser healed silicon as a starting wafer for silicon texturing process which results in small pyramids size.

The whole process of the invention starts with laser healing of saw-damaged silicon wafer. A laser beam (Nd-YAG) with wavelength of 1064 nm is focused onto the silicon wafer. The energy from the laser is absorbed by silicon, which in turn, produces heat that is enough to melt the irradiated silicon. At a very short time, the silicon melts and recrystallizes. The underneath silicon which is still intact acts as seed layer for the liquid molten silicon as it recrystallizes. As consequence, the crystal orientation of recrystallized silicon follows the orientation of the starting wafer. To achieve laser healed silicon over the whole wafer, the laser is then scanned throughout the wafer. As the result of this process, a smoother silicon with much less surface roughness is obtained. Small cracks that are originally present in the starting wafer are removed. Similar usage of laser to remove defective region has been demonstrated by Robinson et. al. for the wafers to be used in integrated circuits [2]. In their invention, the requirement of partial vacuum was necessary to minimize oxygen contamination during the laser annealing process which might then become an issue for final semiconductor device. In the present invention, however, ambient environment is sufficient for the annealing process as any oxygen contamination within the top most layer of silicon will be etched away in the proceeding etching process.

Following the step of laser healing, the silicon wafer is dipped into dilute Hydrofluoric (HF) solution as to remove thin silicon dioxide layer. As consequence of performing the laser healing in ambient environment, a thin silicon dioxide may have formed on the surface due to melting of silicon at high temperature. In a separate place, a KOH solution with additive of isopropyl alcohol (IPA) is prepared. The solution is heated up to a certain temperature for texturing process. Right after dipping the wafer in HF solution, the wafer is rinsed in de-ionized water for further cleaning. Shortly afterward, the wafer is immersed in the heated KOH solution to initiate texturing process. An addition of ultrasonic agitation is utilized to improve the result of texturing process.

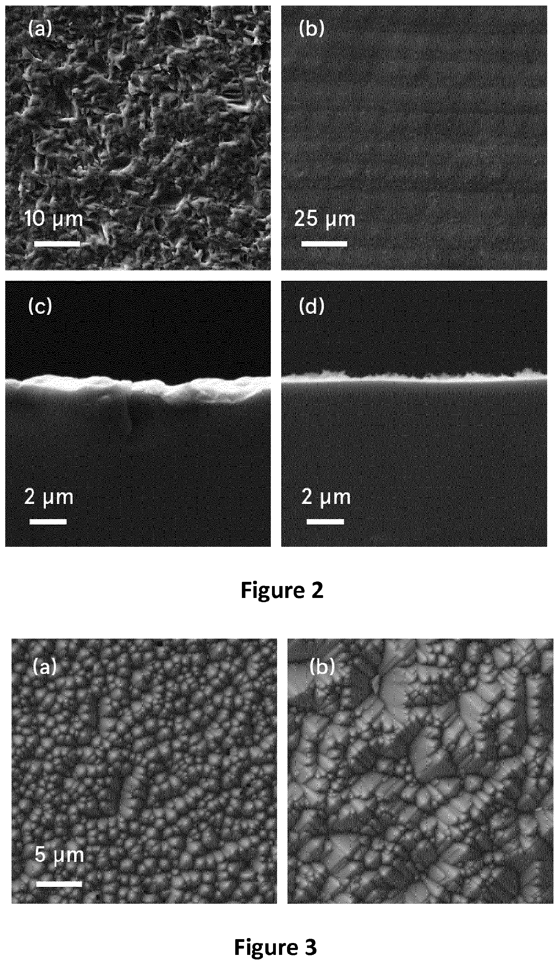

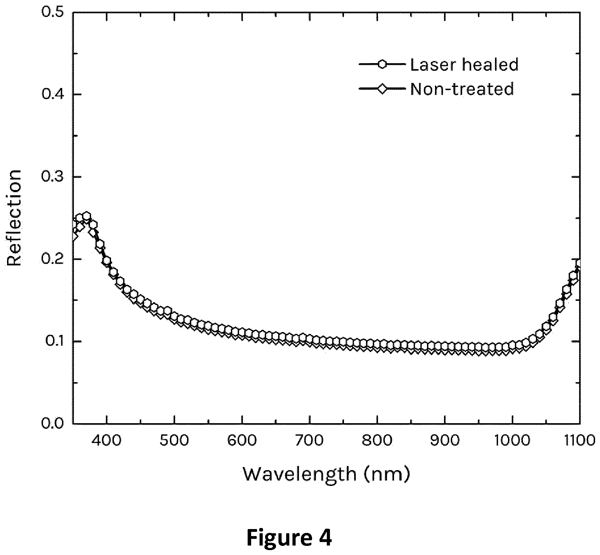

Due to the difference in the surface morphology right after laser healing process, different size of pyramids has been obtained. From Figure 3, it is clear that the size of pyramids for laser healed surface is much smaller and uniform when compared to pyramids for non-treated surface. As mentioned earlier, different pyramids sizes do not necessarily result in substantial difference in the optical performance. This is clearly depicted in Figure 4 which shows the reflection from both surface with different size of pyramids.

Below steps of the method of invention is given as an example and are not limiting.
- Laser with properties given below (to be an example and are not limiting) is scanned throughout the wafer with separation between each consecutive line ranging from 10 to 30 µm (figure 1.b). The power used in the process range from 25% to 30% of the maximum power, to obtain laser healed silicon (figure 1.c)
   - Type: Nd-YAG laser
   - Wavelength: 1064 nm
   - Maximum power: 30 W
   - Pulse width: < 25 ns
   - Repetition rate: 30 kHz
   - Beam diameter: ∼ 50 µm
- The wafer is then immersed into dilute HF solution to remove oxide layer induced in the laser healing process.
- The wafer is put under flowing de-ionized water for rinsing.
- The cleaned wafer is put into mixture of potassium hydroxide and isopropyl alcohol to achieve random upright pyramids with desired size (figure 1.d). As an example texturing process, a solution with concentration 4% of KOH + 2% of IPA is used at 70 °C. The etching time for texturing step is 10 minutes.
- Agitation using ultrasonic has shown huge improvement in the quality of surface texturing
- Finally, the wafer is rinsed in flowing de-ionized water.

### REFERENCES

[1] Y. Han, X. Yu, D. Wang, and D. Yang, "Formation of various pyramidal structures on monocrystalline silicon surface and their influence on the solar cells," J. Nanomater., vol. 2013, 2013.
[2] J. T. Robinson, O. B. Cecil, and R. R. Shah, "Method for removal of minute physical damage to silicon wafers by employing laser annealing." US Patent 4,390,392 A, 1980

## Claims

1. A method of texturing a single crystalline silicon wafer comprising the steps of
• surface healing by laser irradiation, to produce a smooth surface of the silicon wafer due to silicon melting and recrystallization of the silicon at the said surface; and
• texturing, carried out onto the smooth surface of the silicon wafer wherein said texturing step comprises:
a. Immersing the laser scanned wafer into dilute Hydrofluoric acid solution;
b. Putting the wafer under flowing de-ionized water;
c. Putting the wafer into a mixture of potassium hydroxide and isopropyl alcohol;
d. Rinsing the wafer in flowing de-ionized water.

2. A method according to claim 1, wherein laser irradiation is scanned throughout the wafer with a separation between each consecutive line ranging from 10 to 30 µm.

## Patentansprüche

1. Verfahren zum Texturieren eines einkristallinen Siliziumwafers, umfassend die Schritte von
• Oberflächenbehandlung durch Laserbestrahlung, um eine glatte Oberfläche des Siliziumwafers aufgrund von Siliziumschmelzen und Rekristallisation des Siliziums an dieser Oberfläche zu erzeugen und
• Texturierung, durchgeführt auf der glatten Oberfläche des Siliziumwafers
wobei der Texturierungsschritt umfasst
a. Eintauchen des lasergescannten Wafers in verdünnte Flusssäurelösung;
b. Einbringen des Wassers unter strömendes entionisiertes Wasser;
c. Einbringen des Wafers in eine Mischung aus Kaliumhydroxid und Isopropylalkohol;
d. Spülen des Wafers in fließendem entionisiertem Wasser.

2. Verfahren nach Anspruch 1, wobei die Laserbestrahlung über den gesamten Wafer mit einem Abstand zwischen jeder aufeinanderfolgenden Linie im Bereich von 10 bis 30 µm abgetastet wird.

## Revendications

1. Procédé de texturation d'une tranche de silicium monocristallin comprenant les étapes consistant à
• cicatrisation de surface par irradiation laser, pour produire une surface lisse de la tranche de silicium due à la fusion du silicium et à la recristallisation du silicium sur ladite surface et
• texturation, réalisée sur la surface lisse de la tranche de silicium
dans laquelle ladite étape de texturation comprend :
a. Immerger la tranche balayée par laser dans une solution diluée d'acide fluorhydrique ;
b. Placer l'eau sous un courant d'eau désionisée ;
c. Mise de la tranche dans un mélange d'hydroxyde de potassium et d'alcool isopropylique;
d. Rincer la tranche dans de l'eau désionisée en cours d'écoulement.

2. Procédé selon la revendication 1, dans lequel l'irradiation laser est balayée dans toute la tranche avec une séparation entre chaque ligne consécutive allant de 10 à 30 µm.
